## Europäisches Patentamt
## European Patent Office
## Office européen des brevets

(11) Publication number: **0 129 730**
**A2**

# (12) EUROPEAN PATENT APPLICATION

(21) Application number: **84106062.7**

(22) Date of filing: **28.05.84**

(51) Int. Cl.⁴: **G 11 C 13/04**

(30) Priority: **27.06.83 US 508395**

(43) Date of publication of application:
**02.01.85 Bulletin 85/1**

(84) Designated Contracting States:
**DE FR GB**

(71) Applicant: International Business Machines Corporation
Old Orchard Road
Armonk, N.Y. 10504(US)

(72) Inventor: Harley, Richard Timothy
Squirrel Cottage
Beckley Oxford(GB)

(72) Inventor: Macfarlane, Roger Morton
2238 Wellesley
Palo Alto California 94306(US)

(72) Inventor: Shelby, Robert McKinnon
21888 Bear Creek Road
Los Gatos California 95030(US)

(74) Representative: Lancaster, James Donald
IBM United Kingdom Patent Operations Hursley Park
Winchester, Hants, S021 2JN(GB)

(54) **Photo-electro data memory.**

(57) A photo-electro data memory uses a record member comprising the colour centres in sodium fluoride, and which is exposed to laser light of wavelength 577 and 607nm while being subjected first to an electric field of 50 volts, and then of 100 volts. A different photo-electro-reaction is induced in the material where the light falls, depending on the light frequency and the electric field, and these different reactions can be subsequently read.

EP 0 129 730 A2

PHOTO-ELECTRO DATA MEMORY

DESCRIPTION

Technical Field

This invention relates to a photo-electro data memory.

Background Art

The patent to Castro et al, U.S. 4,101,976, describes an optical data storage system that utilizes the frequency dimension to increase the storage capacity significantly. The system includes a storage material, for example, in the form of a block, adapted to undergo a photo-induced reaction upon exposure to light and which exhibits inhomogeneous absorption line broadening. Data bits are stored by selective photo-induced reactions induced by a narrow band laser at specific frequencies within the broad inhomogeneous line. The lifetime of these photo-induced data bits is of the order of years so as to provide a nonvolatile storage system. In a preferred embodiment a material is selected so that the photo-induced reactions can be made reversible thereby permitting, when desired, the erasing of the data bits.

The patent to Carson, U.S. 3,568,167, proposes a storage information system by bleaching colour centres in alkali halides. Some degree of frequency domain storage is obtained by grinding together several materials each bleachable at different wavelengths. Electric fields are used to enhance the bleaching, that is, writing, on crystals cooled to -200°C. The patent to Schneider, U.S. 3,673,578, describes the use of homogeneous electric fields in conjunction with light to create and destroy F centres in alkali halides. This allows writing, erasing and reading with a single wavelength. However, both of these patents utilize electric fields that are homogeneous and these homogeneous electric fields are not used to increase storage density, but rather to aid the writing process.

## Summary of the Invention

It is a primary object of this invention to provide a method of forming an improved photochemical holeburning memory.

It is another object of this invention to provide a method of increasing the storage capacity of a photochemical holeburning memory.

These and other objects are accomplished by a method of burning holes while using an inhomogeneous electric field in a photochemical hole burning memory. When the electric field is changed, the entire spectrum of the memory is swept clean without losing the information so that a new set of holes can be burned thereby increasing the storage capacity. A new set of holes can be burned whenever a different electric field is used. Restoring the original electric field regenerates the holes burned at that field. An example involves the use of colour centres in NaF having a spectral hole burned therein with a laser at an optical frequency at 5770 or 6070A zero phonon lines at a voltage of 50 volts and subsequently at a voltage of 100 volts.

Other objects of this invention will be apparent from the following detailed description, reference being made to the following drawings in which specific embodiments of the invention are shown.

## Brief Description of the Drawings

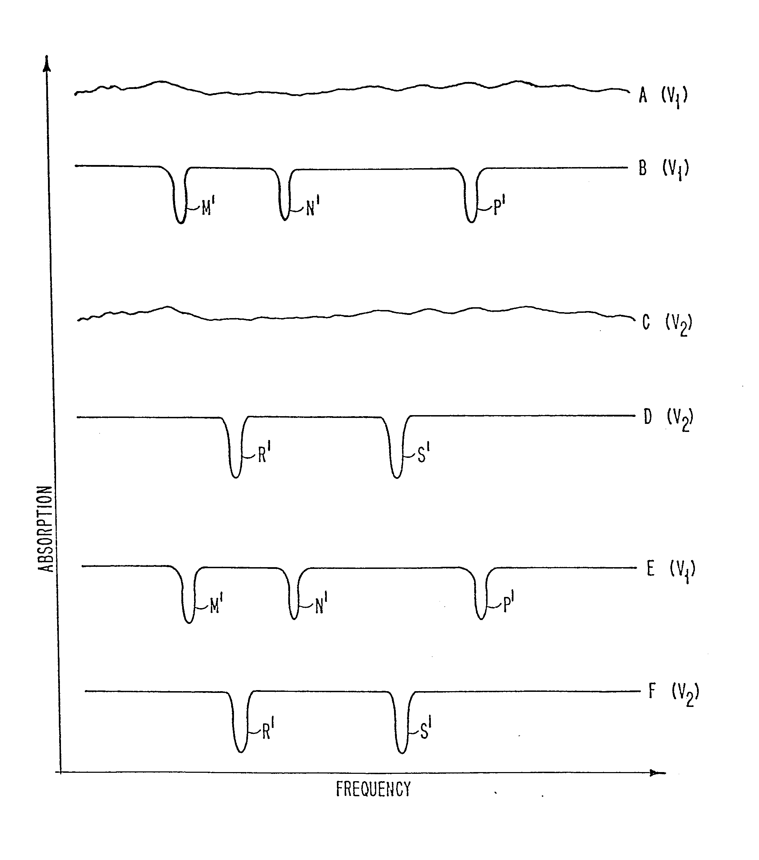

FIGURE 1 illustrates the line profile curves A, B, C, D, E and F resulting from the steps of this process.

## Description of the Preferred Embodiment

The method employed in this invention is applicable to photochemical hole burning memories of the type described in the Castro et al U.S. Patent 4,101,976 which is incorporated herewith by reference thereto. In this type of optical data storage system, the data is stored in the frequency dimension to provide a third dimension. Photochemical hole burning memories employ a storage material which is a layer or block of a material which is adapted to undergo a photo-induced reaction upon exposure to light. The photo-induced reaction would be a photo-chemical reaction or a photochromic reaction, that is, a light-induced change in the material optical properties. Examples are suitable materials such as NaF or LiF which have colour centres. Most materials that have a Stark effect, i.e., the optical transition frequency in the material depends on the electric field applied, are suitable materials. These materials must exhibit inhomogeneous absorption line broadening. Curve A of Figure 1 shows a section of such an inhomogeneously broadened absorption line.

In accordance with this invention, the material is placed in an inhomogeneous electric field. This may be accomplished by applying a fixed voltage to electrodes placed on opposite sides of the material. Examples of voltages that may be applied are 0 to 500 volts depending upon the electrode geometry and the optical spot size. Curve A shows the absorption spectrum over a frequency range while a voltage $V_1$ is applied. The voltage $V_1$ may, for example, be 50 volts.

The next step of the invention is to expose the material to a laser having a frequency in, for example, ultra-violet, visible or infrared radiation and lying inside the inhomogeneous line to burn a hole M' as shown in Curve B. After the hole at M frequency has been burned or created, the laser is adjusted so that laser light having a frequency N enters the material to burn a hole N' as shown in Figure B. Similarly, a hole P' is burned in the material at a frequency P. The three holes M', N' and P' represent three separate bits of data.

In a preferred embodiment of this invention, the next step is to apply a different voltage $V_2$, for example 100 volts, to the material to give a curve as shown for Curve C. While the inhomogeneous field provided by applying the voltage $V_2$ to the electrode is about said material, a laser having a frequency R and later a frequency S strikes the material to form holes R' and S' as shown in Curve D.

The voltage is then changed back to $V_1$ as shown by Curve E. The data bits represented by M', N' and P' may be read while the voltage is at $V_1$.

When the voltage is changed to $V_2$, the data bits at R' and S' frequencies may be read.

Many different values of the voltage can be used and this provides as an additional dimension to those of space and frequency with an increase in information storage capacity. This process has a high signal-to-noise ratio. A small fraction of the inhomogeneous line, for example, about 1%, is used up in burning a pattern of holes at a given value of an applied voltage.

Thus basically the embodiment of the invention makes use of a photoreactive material in which different reactions can be induced, at the same "recording spot or location" in the material, depending on the frequency of the illuminating or exposure light beam for recording, the different reactions being inhomogenous and being detectable i.e. read, by directing light at the recording spot at successively different frequencies in the possible exposure band and detecting absorption characteristics of the material e.g. by determining its entire absorption characteristic. The invention is implemented using a photoreactive material which is photo-electro-reactive in that the different reactions are different and inhomogenous depending not only on the frequency of the recording light beam, but also on the electric field to which the material is subjected. Thus at one spot on the recording material, several digital data bits can be recorded using one electric field, and several further and different bits can be recorded using a second electric field.

0129730

## CLAIMS

1. A method of storing data in an optical storage system in a material exhibiting inhomogeneous line broadening and capable of storing at least two bits of information in the frequency dimension comprising the steps of

applying a fixed voltage at a first level to suitable electrodes to provide a first inhomogeneous electric field about said material, and

exposing said material to light at a first pre-selected frequency with a wavelength narrower than and within the homogeneous linewidth whereby a reaction occurs in said material to form a first hole in the frequency dimension which represents a first data bit.

2. A method as described in claim 1 including the step of exposing said material to light at at least one additional preselected frequency with a wavelength narrower than and within the homogeneous linewidth and different from said first frequency whereby a reaction occurs in said material to form at least one additional hole in the frequency dimension which represents at least one additional data bit.

3. A method of optically storing data in an optical storage system in a material exhibiting inhomogeneous line broadening and capable of storing at least two bits of information in the frequency dimension comprising the steps of

applying a fixed voltage at a first level to suitable electrodes to provide a first inhomogeneous electric field about said material,

exposing said material to light at at least two different preselected frequencies with a wavelength narrower than and within the first homogeneous linewidth whereby a reaction occurs in said material to form at least two holes in the frequency dimension which represent at least two data bits,

0129730.

applying a fixed voltage at a second level to said electrodes to provide a second inhomogeneous electric field about said material, and

exposing said material to light at at least two different preselected frequencies whereby a reaction occurs in said material to form at least two holes in the frequency dimension which represents at least two data bits.

4. Photo-electric data memory system comprising a record member, exposure means for exposing a selected location of the record member to light of at least one preselected frequency, and electrode means for applying at least one preselected electric field to the record member during said exposure, said record member being made of photo-electro-reactive material differently and inhomogeneously responsive depending on said preselected frequency and said electric field.

5. A memory system as claimed in claim 4 in which the material has an inhomogeneously broadened optical absorption band which is bleachable and exhibits a Stark effect.

6. A memory system as claimed in claim 4 or 5 in which the material comprises the colour centres in NaF.

7. A memory system as claimed in claim 4, 5, or 6 in which said preselected frequency has a wavelength of 577nm.

8. A memory system as claimed in claim 4, 5, 6 or 7 in which said preselected frequency has a wavelength of 607nm.